# EUROPEAN PATENT SPECIFICATION

(11) **EP 1 139 566 B1**
(45) Date of publication and mention of the grant of the patent: **23.07.2003**
(21) Application number: 00119016.4
(22) Date of filing: 01.09.2000
(51) Int. Cl.: H03K 17/687, H02H 9/00

(54) **Semiconductor circuit with insulated gate device and associated control circuitry**
Halbleiterschaltung mit einem Bauelement mit isoliertem Gate und einer zugehörigen Kontrollschaltung
Circuit semiconducteur avec un élement à grille isolée et un circuit de control associé

(30) Priority: 30.03.2000 JP 2000097825
(43) Date of publication of application: 04.10.2001
(73) Proprietor: Hitachi, Ltd., Chiyoda-ku, Tokyo 101-8010 (JP)
(72) Inventor: Sakamoto, Kozo, Hitachi Ltd., Intellectual Prop.Gr, Chiyoda-ku, Tokyo 100-8220 (JP)
(74) Representative: Strehl Schübel-Hopf & Partner

(56) References cited:
- EP-A- 0 848 472
- WO-A-96/12347
- DE-A- 3 238 880
- DE-A- 3 424 003
- US-A- 5 390 069

## Description

### BACKGROUND OF THE INVENTION

### FIELD OF THE INVENTION

The present invention relates to an insulated gate semiconductor device with a control circuit taking an insulated gate semiconductor element as an output element, and a semiconductor switch system employing the semiconductor device.

### DESCRIPTION OF THE RELATED ART

A circuit device for spark ignition of an internal combustion engine which elevates a gate voltage associating with elevation of a collector voltage after initiation of a current restricting operation by supplying a current from a collector terminal to a gate terminal in order to solve a problem of causing vibration of collector voltage when a collector current restricting circuit is provided in IGBT using an ignition circuit for spark ignition of an engine for an automotive vehicle or the like, has been disclosed in Japanese Patent Application JP-A-9-280147. A semiconductor element and a MOS power IC associating with this has been disclosed in Japanese Patent Application JP-A-11-289084. On the other hand, an intelligent semiconductor circuit having a driver circuit using a supply voltage generated within a power circuit utilizing a capacitor charging circuit charging a capacitor which supplies power to a CMOS driving circuit from a drain terminal of a power MOSFET without requiring an external voltage supply source for a driving circuit for driving a power element, has been disclosed in Japanese Patent No. 2547544 (JP-A-61-285025).

### SUMMARY OF THE INVENTION

The purpose of the present invention is to provide an insulated gate semiconductor device with a control circuit which can operate stably and at low power consumption.

In the technology disclosed in Japanese Patent Application JP-A-9-280147, a constant current circuit is connected between the collector terminal and the gate terminal for preventing vibration of the collector voltage of the IGBT. Therefore, even when the external gate voltage is zero volts, a current may flow between the collector terminal and the gate terminal when a voltage is applied to the collector. Furthermore, since this current serves for increasing the gate voltage of the IGBT to encounter a problem in that the collector current cannot be shut off completely during OFF state. Also, in the technology disclosed in Japanese Patent Application JP-A-11-289084, as a constant current circuit connected between the collector terminal and the gate terminal of the IGBT, a circuit using a depression type MOS semiconductor element has been disclosed. However, nothing has been studied for saving of power consumption. On the other hand, in the technology disclosed in Japanese Patent No. 2547544, a block circuit construction for supplying a current from a drain terminal to a CMOS circuit via a MOSFET, in which a resistor is connected between a gate and drain, has been disclosed. However, study has not been made for a method for preventing loss current flowing from the drain terminal to the gate terminal when the drain voltage becomes high even when no voltage is applied to the gate.

The present invention has been worked out in view of the problems set forth above. It is an object of the present invention to provide an insulated gate semiconductor device with a control circuit which can operate stably and at low power consumption.

This object is met by either one of the semiconductor devices defined in claims 1 and 2. Preferred embodiments of the invention are set forth in the dependent claims. Claim 14 calls for a power switch system which uses such a semiconductor device.

According to the present invention, even when a current supplied from the external gate terminal is small, the current is supplied to the gate terminal of the first insulated gate semiconductor element (11) from the second terminal (drain terminal) of the first insulated gate semiconductor element (11) through the enhancement type second insulated gate semiconductor element (12). On the other hand, from the second terminal (drain terminal) of the first insulated gate semiconductor element (11), the current is supplied to the control circuit (91) via the enhancement type third insulated gate semiconductor element (13). Accordingly, operation of the insulated gate semiconductor device in the control circuit becomes stable and consumed power of the insulated gate semiconductor device with the control circuit can be reduced.

It should be noted that, as the first insulated gate semiconductor device, MOSFET (Metal Oxide Semiconductor Field Effect Transistor) or IGBT (Insulated Gate Bipolar Transistor) and various other insulated gate semiconductor devices are applicable. Also, in place of the first MOSFET, general MISFET (Metal Insulator Semiconductor Field Effect Transistor) may be applicable. Furthermore, the invention is applicable for various semiconductor devices, such as individual semiconductor device or semiconductor integrated circuit.

As set forth above, according to the present invention, stabilization and reduction of power consumption in operation of the insulated gate semiconductor device with the control circuit becomes possible.

### BRIEF DESCRIPTION OF THE DRAWINGS

The present invention will be understood more fully from the detailed description given hereinafter and from the accompanying drawings of the preferred embodiment of the present invention, which, however, should not be taken to be limitative to the invention, but are for explanation and understanding only.

In the drawings:
Fig. 1 is a circuit diagram of the first embodiment of a semiconductor device according to the present invention;
Fig. 2 is a longitudinal section of the first embodiment of the semiconductor device according to the present invention;
Fig. 3 is a longitudinal section of the second embodiment of the semiconductor device according to the present invention;
Fig. 4 is a circuit diagram of the third embodiment of a semiconductor device according to the present invention;
Fig. 5 is a longitudinal section of the third embodiment of the semiconductor device according to the present invention;
Fig. 6 is a circuit diagram of the fourth embodiment of a semiconductor device according to the present invention; and
Fig. 7 is a longitudinal section of the fourth embodiment of the semiconductor device according to the present invention.

### DETAILED DESCRIPTION OF THE EMBODIMENT

The present invention will be discussed hereinafter in detail in terms of the preferred embodiment of the present invention with reference to the accompanying drawings. In the following description, numerous specific details are set forth in order to provide a thorough understanding of the present invention. It will be obvious, however, to those skilled in the art that the present invention may be practiced without these specific details. In other instance, well-known structure are not shown in detail in order to avoid unnecessary obscurity of the present invention.

### <First Embodiment>

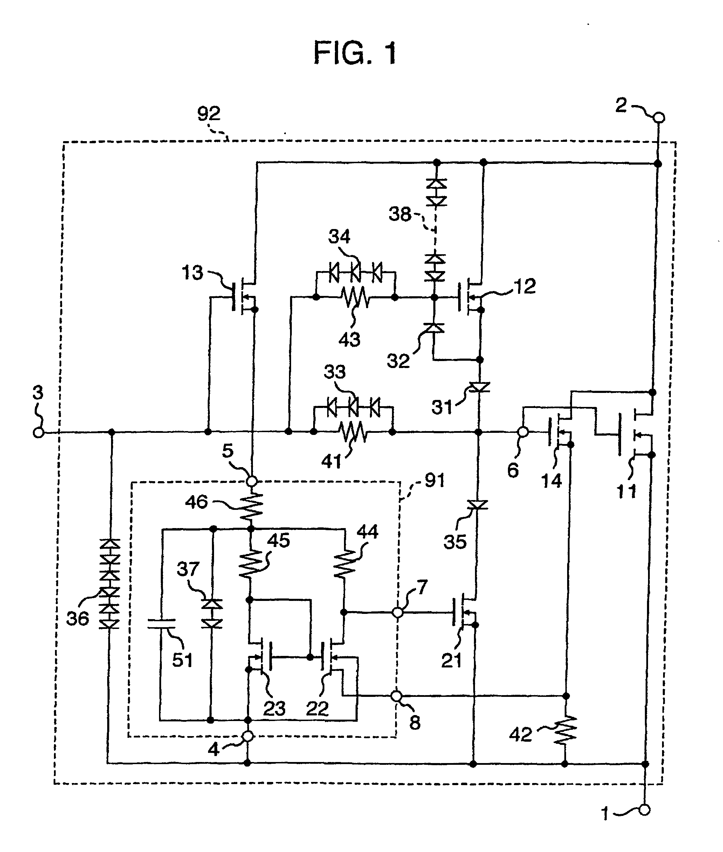

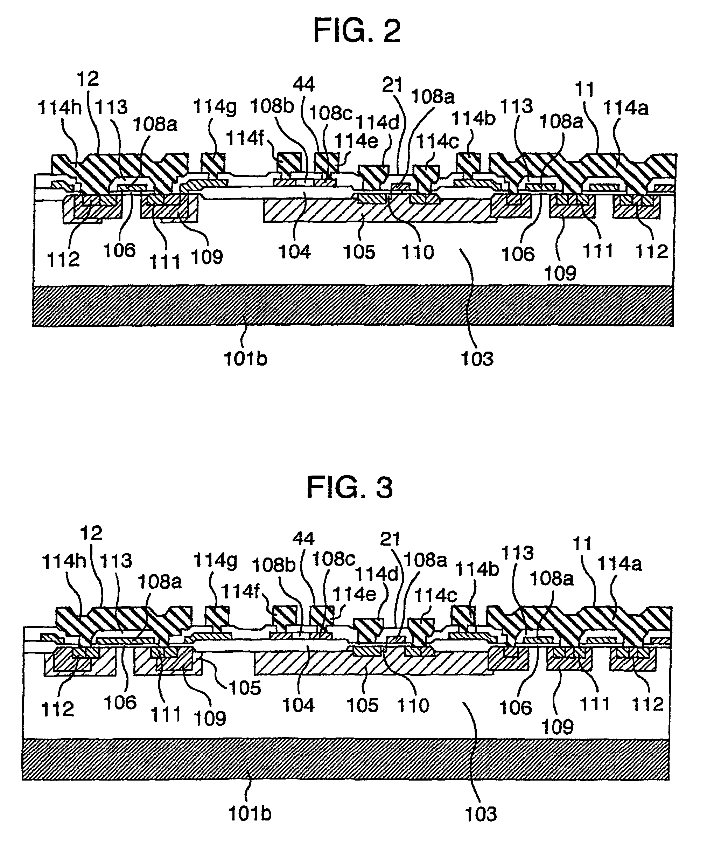

Fig. 1 is a circuit diagram of the first embodiment of the integrated gate semiconductor device with a control circuit according to the present invention, and Figs. 2 and 3 are longitudinal sections of the shown embodiment of the semiconductor device.

A power MOSFET 11 and a control circuit 91 for controlling the power MOSFET 11 are provided in the same packet 92. At least three external terminals of an external gate terminal 3, an external source terminal 1 and an external drain terminal 2 are provided for externally leading electrodes. The external source terminal 1m the source terminal of the power MOSFET 11, a grounding terminal 4 of the control circuit 91 and a source terminal of MOSFET 21 are connected for establishing electrical connection (hereinafter referred to as "connection"). The external drain terminal 2, a drain terminal of the power MOSFET 11, a drain terminal of en enhanced type vertical MOSFET 12 and a drain terminal of an enhanced vertical MOSFET 13 are connected. Between the external gate 3 and a gate terminal 6 of the power MOSFET 11, a resistor 41 serving as a voltage holding element is connected. Between a resistor 41 and the gate terminal 6 of the power MOSFET 11, a drain terminal of the MOSFET 21 and a source terminal of the enhanced type vertical MOSFET 12 are connected. An output terminal 7 of the control circuit 91 and a gate terminal of the MOSFET 21 are connected. A source terminal of the enhanced type vertical MOSFET 13 and a power source terminal 5 of the control circuit 91 are connected.

The control circuit 91 is a differential type comparator circuit for restricting and controlling a drain current flowing between the external drain terminal 2 and the external source terminal 1 to be lower than or equal to a reference current value, and takes MOSFETs 22 and 23 and resistors 44 and 45 as primary elements. Furthermore, a resistor 46 for restricting a current from the vertical MOSFET 13, a diode 37 for restricting an upper limit value of an operation voltage in the control circuit 91, and a capacitor 51 interposed between the ground of a protection circuit and a power source for improving anti-noise characteristics and realizing a constant current characteristics at high precision.

Between a source terminal of a vertical MOSFET 14 and the external source terminal 1, a resistor 41 serving as a voltage holding element is provided. A gate terminal of the vertical MOSFET 14 and the external gate terminal 3 are connected via the resistor 41. A drain terminal of the vertical MOSFET 14 and the external drain terminal 2 are connected. When a drain current of the power MOSFET 11 is increased, a terminal voltage of the resistor 41 serving as the voltage holding element, namely a voltage of an input terminal 8 of the control circuit 91, is increased. A threshold voltage of the MOSFET 22 is set to be lower than a threshold voltage of the MOSFET 23 in the extent of 0.2V. When the voltage of the input terminal 8 of the control circuit 91 becomes higher than or equal to about 0.2V, the MOSFET 22 is turned OFF and the MOSFET 21 is turned ON. Therefore, a drain current of the power MOSFET 11 is restricted within a reference value.

A total width of the gate width of the vertical MOSFET 14 is set to be less than or equal to 1/100, normally less than or equal to about 1/1000 of a total width of the gate width of the power MOSFET 11 so that the drain current of the vertical MOSFET 14 can be small enough in comparison with a total drain current flowing in the external drain terminal 2 to ignore. By this, power loss of the current restricting circuit can be reduced.

Between the source terminal of the enhanced type vertical MOSFET 12 and the gate terminal 6 of the power MOSFET 11, a diode 31 serving as one-way current conducting element is connected. The diode 31 prevents a leak current flowing between drain and source of the vertical MOSFET 12 from flowing from the external gate terminal 3 to the external drain terminal 2.

A diode 35 connected to the MOSFET 21 in series a leak current from flowing from the external drain terminal 2 to the external gate terminal 3 via a parasitic npn transistor presenting in the MOSFET when the potential of the external gate terminal 3 is lower than the potential of the external source terminal 1.

Diodes 33 and 34 are connected in parallel to resistors 41 and 43 for turning OFF the power MOSFET 11 and the vertical MOSFET 12 at high speed even when resistance values of the gate resistors 41 and 43 serving as voltage holding elements connected between the external gate terminal 3, the MOSFET 11 and the MOSFET 12.

On the other hand, in the shown embodiment, since a capacitor 51 is provided between the ground of the protection circuit and the power source, a voltage value of the constant current circuit becomes stable to make constant current characteristics stable.

With the construction set forth above, the following major effect can be achieved by the shown embodiment.
(1) Since the value of the resistor 41 has to be set at high value in an extent from 2 kΩ to 20 kΩ in order to suppress increasing of the gate current by current restricting operation. When the resistor 41 is made large, voltage elevating speed of the gate terminal 6 of the power MOSFET 11 becomes low to make response speed of current restriction low. In the shown embodiment, since the MOSFET 12 connected to the external drain terminal 2 is used for controlling the gate terminal 6 of the power MOSFET 11, even when the resistance value of the resistor is large, the voltage of the gate terminal 6 can be elevated at high speed in order to quickly reach the drain current of the power MOSFET 11 to a target value. Therefore, vibration of the drain voltage of the power MOSFET 11 can be reduced to control stably.
(2) Since the drain current of the MOSFET 12 controlling the gate terminal 6 is supplied from the external drain terminal, it becomes unnecessary to increase the gate current to be supplied to the external gate terminal 3. Therefore, it can be driven at low power consumption. The drain current of the MOSFET 13 is supplied to the control circuit 91 from the power source terminal 5, similarly to the MOSFET 12. Therefore, even when the current is not supplied from the external gate terminal 3, the control circuit 91 can operate. Furthermore, the current flowing the control current 91 can be effectively used as a current to be supplied to a load. Therefore, low power consumption drive becomes possible. Here, respective currents flowing in the vertical MOSFETs 12 and 13 do not necessarily increase in proportion to the current of the power MOSFET 11. However, by setting respective currents flowing in the vertical MOSFETs 12 and 13 to be less than or equal to about 1/10, normally less than or equal to 1/100 of the total current flowing through the external drain terminal 2 so as not to be a cause of degradation of current restriction precision.
(3) The vertical MOSFETs 12 and 13 use enhancement type elements and control elements in the same package by the external gate terminal. Therefore, when the power MOSFET 11 is OFF, the MOSFET 12 also becomes OFF condition so as not to flow a wasteful leak current from the external drain terminal to the external gate terminal. On the other hand, when the vertical MOSFET 12 is formed with the enhanced type element, since the leak current does not flow from the external drain terminal to the external gate terminal, this leak current flow to the gate resistor 41 to place the power MOSFET slightly conductive state to prevent the leak current flow flowing from the external drain terminal to the external source terminal. Therefore, the leak current does not flow to the external gate terminal 3 and the external source terminal from the external drain terminal 2 in OFF condition to lower power consumption in stand-by state.

When the enhancement type element is used as the vertical MOSFET, the drain current value flowing through the MOSFET 12 is increased when the voltage of the external gate terminal 2 is increased to possibly cause difficulty in establishing current balance of the MOSFET 12 and the MOSFET 21. As a measure for this, in the shown embodiment, a diode 32 serving as a voltage restricting element is provided between a source terminal and a gate terminal of an insulated gate semiconductor element 12. On the other hand, by setting the gate width of the MOSFET 12 shorter than the gate width of the power MOSFET in the extent of more that or equal to two digits to make the drain current flowing through the insulated gate semiconductor element 12 not to be excessive. By this, stable and high precision current restriction characteristics can be maintained.

Furthermore, in the shown embodiment, by employing enhanced type vertical MOSFET as the vertical MOSFETs 12, 13, the foregoing stand-by power can be eliminated. However, when the threshold voltages of the vertical MOSFETs 12 and 13 are set to as high as that of the power MOSFET 11, when the voltage of the external gate terminal 3 is low, the voltage of the power source terminal 5 of the control circuit 91 becomes low to possibly cause failure of normal operation of the control unit 5. On the other hand, it is also possible to cause difficulty in supplying sufficient current from the vertical MOSFET 12 to the gate terminal 6. Therefore, it is desirable that absolute values of the threshold voltages of the vertical MOSFETs 12 and 13 are smaller than the absolute value of the threshold voltage of the power MOSFET 11.

Namely, in case of n channel element,
0 < threshold voltages of vertical MOSFETs 12 and 13 < threshold voltage of the power MOSFET 11 is set. On the other hand, in case of p channel element,
0 > threshold voltages of vertical MOSFETs 12 and 13 > threshold voltage of the power MOSFET 11 is set. By this, even when the voltage of the external gate voltage is low, the vertical MOSFETs 12 and 13 are turned ON.
(4) By setting a time constant determined by a product of an input capacity of the vertical MOSFET 12 and the gate resistance 43 to be smaller than a time constant determined by a product of an input capacity for the gate terminal 6 of the power MOSFET 11 and the gate resistance, when the voltage is applied to the external gate terminal 3, the vertical MOSFET 12 is initially turned ON to supply a current to the gates of the vertical MOSFETs 11 and 14 from the external drain terminal 2. Therefore, even the enhancement type instead of the depression type, of vertical MOSFET 12 may turn ON the vertical MOSFET 14 at high speed. On the other hand, even if the gate resistance 41 is large and the gate current to be supplied to the gate terminal 6 from the external gate terminal 3 via the gate resistor 41 is small, the power MOSFET 11 can be turn ON.
(5) In the shown embodiment, when the voltage of the external drain terminal 2 is lowered, it becomes difficult to supply a current from the vertical MOSFET 13 to the power source terminal 5 of the control circuit 91 to automatically releasing holding of the current restriction characteristics of the power MOSFET . Namely, in the operating condition where the drain voltage is low where heating of the shown semiconductor device will not cause any problem, namely when the drain voltage is less than or equal to about 3V, restriction of the drain current is not performed to increase a maximum rated current of the drain current. When the drain voltage becomes higher than or equal to about 3V and power consumption of the power MOSFET creates a problem, the drain current characteristics is restricted to improve breakdown strength in the load shorting condition.
(6) In the shown embodiment, since the diode string 38 acting as the voltage restricting element between the drain terminal of the enhancement type vertical transistor 12 and the gate terminal is provided, in the inductive load, when the external gate terminal 3 is turned OFF by abrupt drop, the voltage between the external drain terminal 2 and the external source terminal 1 is abruptly increased. In response to this, at first, the diode string is broken down and then the vertical MOSFET is turned ON to increase voltage of the gate terminal 6 of the power MOSFET 11 by the drain current of the vertical MOSFET 12 to restrict abrupt increase of the voltage between the external drain terminal 2 and the external source terminal 1. Accordingly, when an excessive voltage is applied between the external drain terminal 2 and the external source terminal 1, the power MOSFET is abruptly turned ON using the vertical MOSFET 12 having large current supply capacity. Therefore, excessive voltage protection effect for protecting the semiconductor device so as not to be damaged by the excessively large drain voltage applied to the power MOSFET 11 can be improved.

It should be noted that in Fig. 1 of the shown embodiment, the resistor 41 is used as the voltage holding element for holding the voltage between the external gate terminal 3 and the gate terminal 6 of the power MOSFET 11 when the MOSFET 21 is turned ON to restrict the drain current of the power MOSFET 11. However, it is also possible that the drain and the source of the MOSFET are connected to the terminals 3 and 6 to serve as the voltage holding element 41 in place of the resistor 41.

Fig. 2 shows an example of device structure for realizing the circuit of Fig. 1. Structure of the power MOSFET, the MOSFET 21, the resistor 44 and the vertical MOSFET 12 for representation. The reference numeral 101a denotes a high concentration n type substrate, 103 denotes a n-type epitaxial layer, 104 denotes a field insulation layer, 105 denotes a p-type well diffusion layer to be a body of a horizontal MOSFET, 106 denotes a gate oxide film, 108a denotes a polycrystalline silicon layer diffused high concentration n-type impurity, 108b denotes a polycrystalline silicon layer diffused high concentration p-type impurity, 109 denotes a p-type diffusion layer, 110 denotes a low concentration n-type diffusion layer, 111 denotes a high concentration n-type diffusion layer, 112 denotes a high concentration p-type diffusion layer, 113 denotes a protection film. The reference numeral 114a denotes a source electrode of the power MOSFET 11, 114b denotes a gate electrode, 114c denotes a source electrode of the MOSFET 21, 114d denotes a drain electrode, 114e and 114f denote electrodes of resistors 44, 114g denotes the gate electrode of the vertical MOSFET 12 and 114h denotes a source electrode.

Drain regions of the power MOSFET 11 and the vertical MOSFET 12 have the high concentration n-type substrate 101 and the n-type epitaxial layer 103 in common. Respective body regions are separated by the n-type epitaxial layer 103. Furthermore, while not illustrated in Fig. 2, the vertical MOSFET 13 of Fig. 1 also have the high concentration n-type substrate 101a as the drain region of the power MOSFET 11 similarly to the vertical MOSFET 12 and the n-type epitaxial layer 103 in common, and the body region is separated by the n-type epitaxial layer 103. Therefore, the power MOSFET 11 and the vertical MOSFETs 12 and 13 may be formed by using the conventional power MOSFET process. Furthermore, since particular element separating region is not required to be added for separating the power MOSFET and the vertical MOSFETs 12 and 13, the controlling MOSFETs 12 and 13 can be formed on the same chip in inexpensive process to make the circuit compact.

Furthermore, the body region of the MOSFETs 21-23 are formed within the n-type epitaxial layer as the drain region of the power MOSFET, on the same semiconductor chip with the power MOSFET 11, the controlling MOSFETs 21 to 23 are formed using the conventional power MOSFET process without adding any particular element separation process. Furthermore, by forming the resistors 41 to 43 or diodes or diode strings 31 to 38 using the silicon layer on the insulation layer, such as polycrystalline silicon layer or the like, the semiconductor circuit elements which are required to be formed within the package 92 can be formed on the same semiconductor chip using the conventional power MOSFET process. By advancing integration, down-sizing of the circuit can be achieved at low cost. As one of variations of construction of the semiconductor device, similar effect can be obtained by integrating the circuit element units shown in the package 92 of Fig. 1 on the same package or the same module together with other circuit elements.

### <Second Embodiment>

Fig. 3 is a longitudinal section of the second embodiment of the semiconductor device according to the present invention which shows an example of device structure different from Fig. 2 for realizing the circuit of Fig. 1.

In the shown embodiment, in order to make the threshold voltages of the threshold voltage of the vertical MOSFETs 12, 13 lower than the threshold voltage of the power MOSFET 11, the p-well region 105 used in the body region of the MOSFETs 21 and 22 is also used as channel diffusion layer (body region) of the vertical MOSFETs 12 and 13. An impurity concentration of the surface of a p-well region 109 used as the channel diffusion layer of the power MOSFET 11 is set at higher concentration than an impurity concentration on the surface of the p-well region 105 used as the body region of the MOSFET 21 for setting the threshold voltage of the power MOSFET 11 is set at 1.5V to 3.5V, and the threshold voltages of the vertical MOSFETs 12 and 13 are set about 0.5V to 1.5V which is substantially the same value as that of the MOSFET 21 or the like. Therefore, in the shown embodiment, even when the voltage of the external gate terminal 3 is low, the voltage of the power source terminal 5 of the control circuit 92 is difficult to be low to expand normal operation range of the control circuit 5. Furthermore, sufficient current can be easily supplied from the vertical MOSFET 12 to the gate terminal 6.

The shown embodiment can be realized by forming the p-well region of low impurity concentration even in the region to be a channel of the vertical MOSFET before forming the gate oxide film 106 of the vertical MOSFET. Therefore, the threshold voltage of the vertical MOSFETs 12 and 13 can be set to be as low as that of the MOSFET 21. It should be noted that breakdown voltage between the drain and source of the vertical MOSFETs 12 and 13 is required to be comparable with the breakdown voltage between the drain and source of the power MOSFET 11. A channel length of the vertical MOSFET is formed to be longer than the channel length of the power MOSFET 11 for avoiding degradation of breakdown voltage by punch through in the channel portion.

### <Third Embodiment>

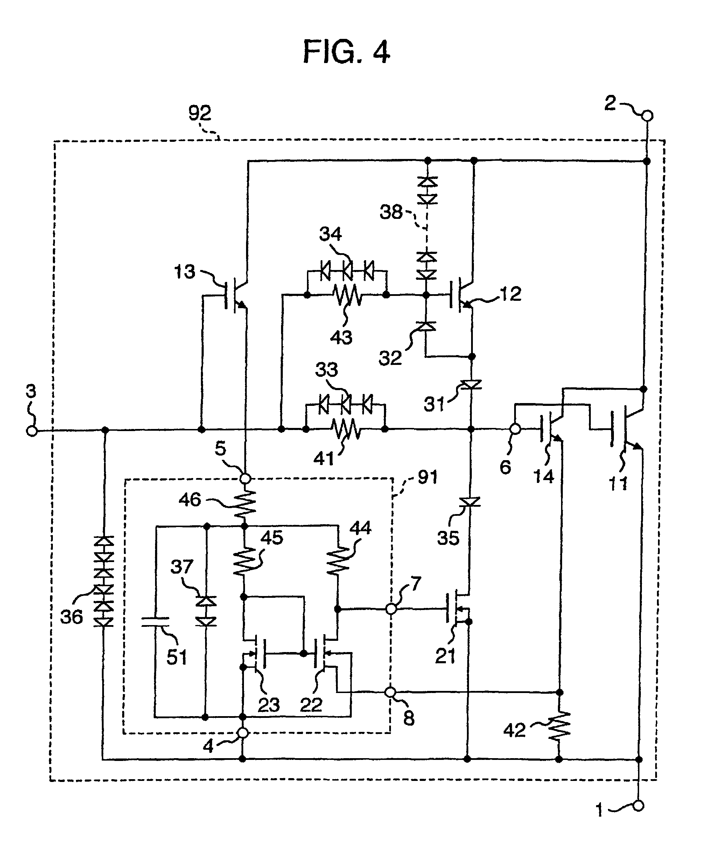

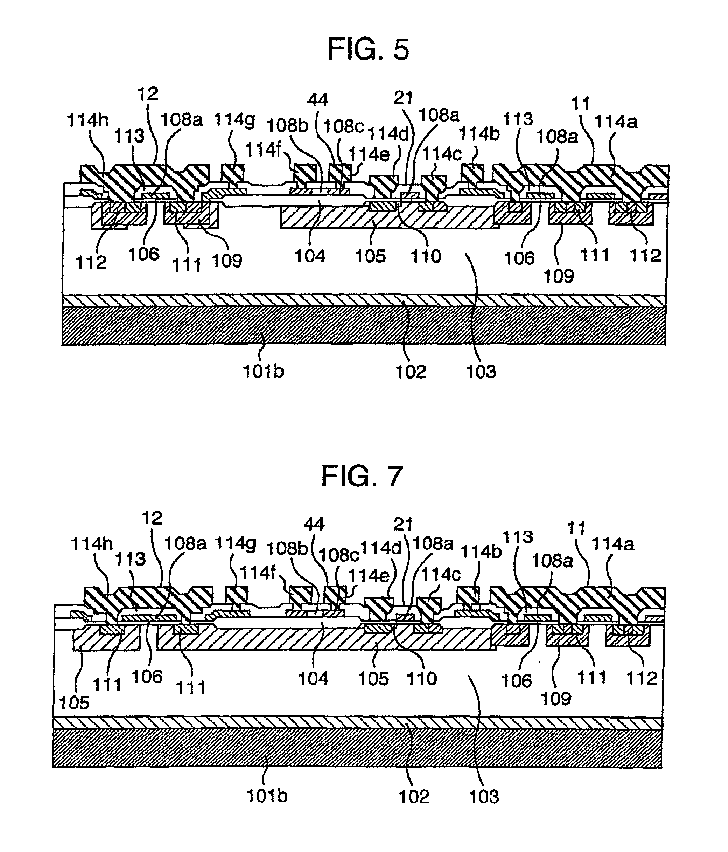

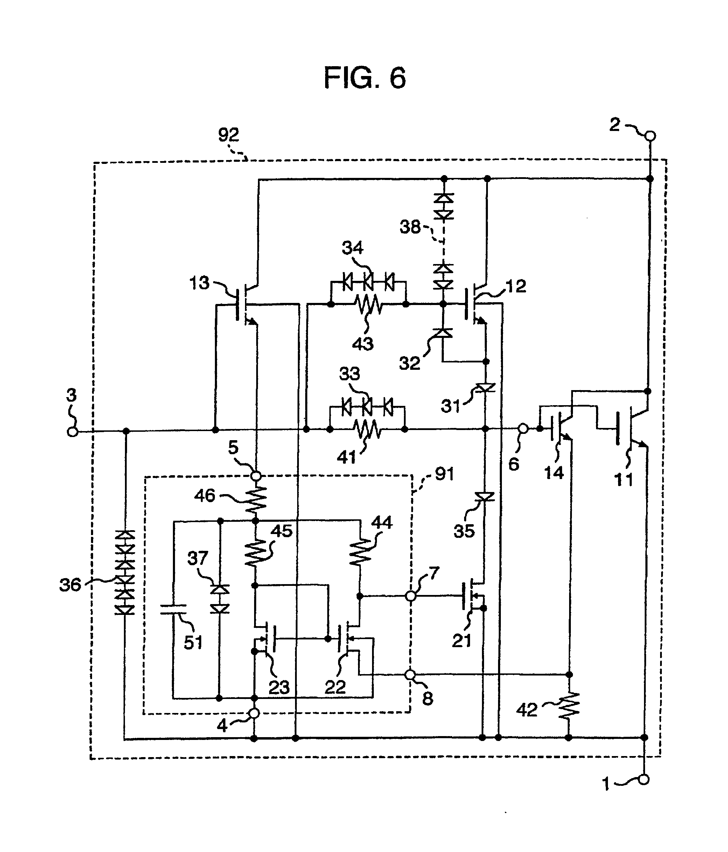

Fig. 4 is a circuit diagram of the third embodiment of the semiconductor device according to the present invention and Figs. 5 and 6 are longitudinal section of the shown embodiment of the semiconductor device.

The shown embodiment is formed by replacing the power MOSFET 11 and the vertical MOSFETs12, 13 and 14 with power IGBT 11 and vertical IGBTs 12, 13 and 14. The reference numeral 1 denotes the external emitter terminal, 2 denotes the external collector terminal, 3 denotes the external gate terminal. The reference numeral 11 denotes an outputting IGBT, 12 to 14 denote vertical IGBTs connected the collectors thereof to the outputting power IGBT 11. Accordingly, the shown circuit has the similar circuit construction as the first embodiment shown in Fig. 1 and the major effects are similar to the first embodiment. Namely, (1) suppression of vibration of collector voltage and stabilizing of control for the power IGBT, (2) driving at low power consumption, (3) lower power consumption during stand-by state, (4) high speed switching, (5) simultaneously improving maximum rated current value and load shorting breaking strength, and (6) improving excessive voltage protection characteristics.

Fig. 5 shows an example of the longitudinal section of the semiconductor device realizing the circuit of Fig. 4, in which structures of the power IGBT 11, the MOSFET 21, the resistor 44 and the vertical IGBT 12 are shown as representation.

A difference between the shown structure and Fig. 2 is that since the IGBT is formed in place of the power MOSFET, in place of the high concentration n-type substrate 101a, a high concentration p-type substrate 101b and n-type buffer region (n-type base region) 102 are provided. Also, 114a denotes an emitter electrode of the power IGBT 11, 114 denotes a gate electrode, 114g denotes a gate electrode of the vertical IGBT 12 and 114h denotes an emitter electrode.

In the shown structure, the power IGBT 11 commonly uses the high concentration p-type substrate 101b as the collector region of the vertical IGBT 12, and also commonly uses the n-type epitaxial layer (n-type base region) 102 as the n-type base region, and the power IGBT 11 and the body region of the vertical IGBT 12 are separated by the n-type epitaxial layer 103. Furthermore, while not illustrated in Fig. 2, the vertical IGBT 13 commonly uses the high concentration p-type substrate as the collector region of the power IGBT 11 similarly to the vertical IGBT 12, and also commonly uses the n-type epitaxial layer as the n-type base region. The body regions of the power IGBT 11 and the vertical IGBT 13 are also separated by the n-type epitaxial layer 103. Therefore, the power IGBT and the vertical IGBTs 12 and 13 are formed using the conventional IGBT process. Furthermore, since particular element separating region is unnecessary to add for separating the power IGBT 11 and the vertical IGBTs 12 and 13, the controlling vertical IGBTs 12 and 13 can be formed on the same chip through inexpensive process. Therefore, down-sizing of the circuit becomes possible.

Furthermore, in the shown embodiment of the semiconductor device, the body region of the MOSFETs 21 to 23 are formed within the n-type epitaxial layer as the n-type base region of the power IGBT 11. Also, on the same semiconductor chip with the power MOSFET 11, the controlling MOSFETs 21 to 23 are formed using the conventional IGBT process without adding any particular element separation process. Furthermore, by forming the resistors 41 to 43 or diodes or diode strings 31 to 37 using the silicon layer on the insulation layer, such as polycrystalline silicon layer or the like, the semiconductor circuit elements which are required to be formed within the package 92 can be formed on the same semiconductor chip using the conventional IGBT process. By advancing integration, down-sizing of the circuit can be achieved at low cost. As one of variations of construction of the semiconductor device, similar effect can be obtained by integrating the circuit element units shown in the package 92 of Fig. 1 on the same package or the same module together with other circuit elements.

In case of the IGBT as in the shown embodiment, since the pn junction diode is present between the n-type buffer region 102 (n-type base region) and the high concentration p-type substrate (collector region) 101b, the breakdown voltage in the reverse direction of the diode is higher than the breakdown voltage between the external gate terminal 2 and the external source terminal 1. Therefore, when the leak current is small, the diode 31 provided for suppressing the leak current from the external gate terminal 3 to the external collector terminal s in Fig. 4 can be omitted.

For others, the shown embodiment may achieve the similar effect to the case of the power MOSFET as discussed in connection with the first embodiment.

### <Fourth Embodiment>

Fig. 6 is a circuit diagram of the fourth embodiment of the semiconductor device according to the present invention and Fig. 7 is a longitudinal section showing the structure of the shown embodiment of the semiconductor device.

In the shown embodiment, the body region (p-well region) of the vertical IGBTs 12 and 13 shown in Fig. 4 is separated from an emitter region and connect to the external emitter terminal 1 as a minimum potential region of the shown embodiment of the semiconductor device. Particularly, as shown in Fig. 7, an emitter electrode 114h of the vertical IGBT 12is not connected to the p-well region 105 as the body region and connect only to the emitter region 111 of the IGBT. The p-well region 105 as the body region of the vertical IGBT 12 is connected to the p-well region 105 of the MOSFET 21 to conduct with the emitter electrode 114a of the power IGBT 11. It should be noted that, in Fig. 7, the left side p-well region 105 of the vertical IGBT 12 is connected to the right side p-well region in other section. In case of the shown embodiment, even if a noise current flows to the body region (p-well region 105) of the vertical IGBTs 12 and 13, when the vertical IGBTs 12 and 13 are OFF, current will never flow to the gate terminal 6 of the power MOSFET 11 and directly flow into the external emitter terminal 1. Accordingly, the current restriction circuit becomes resistive against the noise and will not cause malfunction. It should be noted that in the shown embodiment, the n type diffusion layer 111 is not directly connected to the high concentration p-type diffusion layer 108 as high as 2 X 10¹⁷ cm⁻³ or more, to be used as a channel diffusion layer of the power IGBT 11. By this, degradation of breakdown voltage between the emitters of the vertical IGBTs 12 and 13 and the external emitter 1 to as not to lower the voltage to be applied to between the external gate terminal 2 and the external source terminal 1. It should be noted that while the shown embodiment is illustrated in terms of an example of the IGBT, similar is true even in the case of power MOSFET. It is possible to separate the body of the vertical MOSFETs 12 and 13 of Fig. 1 from the source to connect with the external source terminal. In this case, the current restriction circuit becomes resistive against the noise and will never cause malfunction. On the other hand, in case of the IGBT shown in Fig. 7, degradation of breakdown voltage between the external gate terminal 3 and the external source terminal 1 can be successfully avoided.

It should be noted that in the foregoing embodiment, the vertical IGBTS (vertical MOSFETs) 12 and 13 are enhanced type for reducing the power consumption, however, the effects for separating electrode of the body region for preventing malfunction, similar effects can be achieved equally even when the depression type elements are used as the vertical IGBTs (vertical MOSFETs) 12 and 13.

As set forth above, while embodiments of the present invention have been discussed. The present invention should not be take to be limitative to the shown embodiments of the invention. For example, while the n-type power MOSFET or IGBT are mainly n-channel type, similar effect can be expected as the p-channel type. As set forth above, various construction can be taken within a principle of the technical range of the present invention.

## Claims

1. An insulated gate semiconductor device with a control circuit (91) comprising:
a first insulated gate semiconductor element (11) and a control circuit (91) controlling said first insulated gate semiconductor element (11) on the same package (92);
at least three external terminals including an external gate terminal (3), an external first terminal (1) and an external second terminal (2) provided for externally leading electrodes outside of said package (92);
said external first terminal (1), a first terminal of said first insulated gate semiconductor element (11), a grounding terminal (4) of said control circuit (91) and a source terminal of a first MOSFET (21) being connected electrically;
said external second terminal (2), a second terminal of said first insulated gate semiconductor element (11) and a second terminal of an enhancement type second insulated gate semiconductor element (12) being connected electrically;
said external gate terminal (3) and a gate terminal of said enhancement type second insulated gate semiconductor element (12) being connected electrically;
a first voltage holding element (41) being connected between said external gate terminal (3) and a gate terminal (6) of said first insulated gate semiconductor element (11);
a drain of said first MOSFET (21) and a first terminal of said enhancement type second insulated gate semiconductor element (12) being electrically connected between said first voltage holding element (41) and the gate terminal of said first insulated gate semiconductor element (11);
an output terminal (7) of said control circuit (91) and a gate of said first MOSFET (21) being connected electrically, whereby the supply current for the control circuit is drawn from the current flowing through the said external second terminal.

2. An insulated gate semiconductor device with a control circuit (91) comprising:
a first insulated gate semiconductor element (11) and a control circuit (91) controlling said first insulated gate semiconductor element (11) on the same package (92);
at least three external terminals including an external gate terminal (3), an external first terminal (1) and an external second terminal (2) provided for externally leading electrodes outside of said package (92);
said external first terminal (1), a first terminal of said first insulated gate semiconductor element (11), a grounding terminal (4) of said control unit and a source terminal of a first MOSFET (21) being connected electrically;
said external second terminal (2), a second terminal of said first insulated gate semiconductor element (11) and a second terminal of an enhancement type third insulated gate semiconductor element (13) being connected electrically;
said external gate terminal (3) and a gate terminal of said enhancement type third insulated gate semiconductor element (13) being connected electrically;
a first voltage holding element (41) being connected between said external gate terminal (3) and a gate terminal (6) of said first insulated gate semiconductor element (11);
a drain of said first MOSFET (21) being electrically connected between said first voltage holding element (41) and the gate terminal of said first insulated gate semiconductor element (11);
an output terminal (7) of said control circuit (91) and a gate of said first MOSFET (21) being connected electrically; and
a first terminal of said enhancement type third insulated gate semiconductor element (13) and a power source terminal (5) of said control circuit (91) being connected electrically.

3. The device of claim 1, further comprising an enhancement type third insulated gate semiconductor element (13) having a first terminal connected to a power source terminal (5) of said control circuit (91), a second terminal connected to said external second terminal (2) and a gate terminal connected said external gate terminal (3).

4. The device of claim 1 or 3, wherein a one-way current conducting element (31) is provided between the first terminal of said enhancement type second insulated gate semiconductor element (12) and the gate terminal of said first insulated gate semiconductor element (11).

5. The device of claim 1 or 3, wherein a first voltage restricting element (32) is provided between the first terminal and the gate terminal of said second enhancement type insulated gate semiconductor element (12).

6. The device of any one of claims 1 and 3 to 5, wherein a second current restricting element is provided between the second terminal and the gate terminal of said enhancement type second insulated gate semiconductor element (12).

7. The device of any preceding claim, wherein
a second voltage holding element (43) is provided between a first terminal of a fourth insulated gate semiconductor element (14) and the external first terminal (1);
a gate terminal of said fourth insulated gate semiconductor element (14) and said external gate terminal (3) are connected electrically;
a second terminal of said fourth insulated gate semiconductor element (14) and said external second terminal (2) are connected electrically; and
means for increasing a drain current of said first MOSFET (21), when a terminal voltage of said second voltage holding element (43) is increased, is provided.

8. The device of any one of claims 1 and 3 to 6, wherein said first and second insulated gate semiconductor elements (11, 12) are MOS type semiconductor elements having a common drain region and having body regions separated by said drain region.

9. The device of any one of claims 2 to 6, wherein said first and third insulated gate semiconductor elements (11, 13) are MOS type semiconductor elements having a common drain region and having body regions separated by said drain region.

10. The device of any one of claims 1 and 3 to 6, wherein said first and second insulated gate semiconductor elements (11, 12) are IGBTs having a common first conductivity type collector region, a common second conductivity type base region, and first conductivity type body regions separated by a second conductivity type base region.

11. The device of any one of claims 2 to 6, wherein said first and third insulated gate semiconductor elements (11, 13) are IGBTs having a common first conductivity type collector region, a common second conductivity type base region, and first conductivity type body regions separated by a second conductivity type base region.

12. The device of any one of claims 1 and 3 to 6, wherein the body region of said second insulated gate semiconductor element (12) and a semiconductor region of the first terminal are separately wired.

13. The device of any one of claims 2 to 6, wherein the body region of said third insulated gate semiconductor element (13) and a semiconductor region of the first terminal are separately wired.

14. A power switch system with a current restricting function for driving a load by conducting and blocking control between first and second terminals by the insulated gate semiconductor device of any preceding claim.

## Patentansprüche

1. Halbleitervorrichtung mit isoliertem Gate und mit einer Steuerschaltung (91), umfassend
ein erstes Halbleiterbauelement (11) mit isoliertem Gate und eine im gleichen Gehäuse (92) vorhandene Steuerschaltung (91) zur Steuerung des ersten Halbleiterbauelements (11),
mindestens drei externe Anschlüsse, zu denen ein externer Gate-Anschluß (3), ein erster externer Anschluß (1) und ein zweiter externer Anschluß (2) für aus dem Gehäuse (92) nach außen führende externe Elektroden gehören,
wobei der erste externe Anschluß (1), ein erster Anschluß des ersten Halbleiterbauelements (11), ein Masseanschluß (4) der Steuerschaltung (91) und ein Source-Anschluß eines ersten MOSFETs (21) elektrisch miteinander verbunden sind,
wobei der zweite externe Anschluß (2), ein zweiter Anschluß des ersten Halbleiterbauelements (11) und ein zweiter Anschluß eines zweiten Halbleiterbauelements (12) des Enhancement-Typs mit isoliertem Gate elektrisch miteinander verbunden sind,
wobei der externe Gate-Anschluß (3) und ein Gate-Anschluß des zweiten Halbleiterbauelements (12) elektrisch miteinander verbunden sind,
wobei ein erstes Spannungshalteelement (41) zwischen dem externen Gate-Anschluß (3) und einem Gate-Anschluß (6) des ersten Halbleiterbauelements (11) liegt,
wobei ein Drain des ersten MOSFETs (21) und ein erster Anschluß des zweiten Halbleiterbauelements (12) zwischen dem ersten Spannungshalteelement (41) und dem Gate-Anschluß des ersten Halbleiterbauelements (11) liegen, und
wobei ein Ausgangsanschluß (7) der Steuerschaltung (91) und ein Gate des ersten MOSFETs (21) elektrisch miteinander verbunden sind, so daß der Versorgungsstrom für die Steuerschaltung aus dem durch den zweiten externen Anschluß fließenden Strom gezogen wird.

2. Halbleitervorrichtung mit isoliertem Gate und mit einer Steuerschaltung (91), umfassend
ein erstes Halbleiterbauelement (11) mit isoliertem Gate und eine im gleichen Gehäuse (92) vorhandene Steuerschaltung (91) zur Steuerung des ersten Halbleiterbauelements (11),
mindestens drei externe Anschlüsse, zu denen ein externer Gate-Anschluß (3), ein erster externer Anschluß (1) und ein zweiter externer Anschluß (2) für aus dem Gehäuse (92) nach außen führende externe Elektroden gehören,
wobei der erste externe Anschluß (1), ein erster Anschluß des ersten Halbleiterbauelements (11), ein Masseanschluß (4) der Steuerschaltung (91) und ein Source-Anschluß eines ersten MOSFETs (21) elektrisch miteinander verbunden sind,
wobei der zweite externe Anschluß (2), ein zweiter Anschluß des ersten Halbleiterbauelements (11) und ein zweiter Anschluß eines dritten Halbleiterbauelements (13) des Enhancement-Typs mit isoliertem Gate elektrisch miteinander verbunden sind,
wobei der externe Gate-Anschluß (3) und ein Gate-Anschluß des dritten Halbleiterbauelements (13) elektrisch miteinander verbunden sind,
wobei ein erstes Spannungshalteelement (41) zwischen dem externen Gate-Anschluß (3) und einem Gate-Anschluß (6) des ersten Halbleiterbauelements (11) liegt,
wobei ein Drain des ersten MOSFETs (21) zwischen dem ersten Spannungshalteelement (41) und dem Gate-Anschluß des ersten Halbleiterbauelements (11) liegt,
wobei ein Ausgangsanschluß (7) der Steuerschaltung (91) und ein Gate des ersten MOSFETs (21) elektrisch miteinander verbunden sind, und
wobei ein erster Anschluß des dritten Halbleiterbauelements (13) und ein Versorgungsanschluß (5) der Steuerschaltung (91) elektrisch miteinander verbunden sind.

3. Vorrichtung nach Anspruch 1 mit ferner einem dritten Halbleiterbauelement (13) des Enhancement-Typs mit isoliertem Gate, das einen mit dem Versorgungsanschluß (5) der Steuerschaltung (91) verbundenen ersten Anschluß, einen mit dem zweiten externen Anschluß (2) verbundenen zweiten Anschluß und einen mit dem externen Gate-Anschluß (3) verbundenen Gate-Anschluß aufweist.

4. Vorrichtung nach Anspruch 1 oder 3, wobei zwischen dem ersten Anschluß des zweiten Halbleiterbauelements (12) und dem Gate-Anschluß des ersten Halbleiterbauelements (11) ein Einweg-Stromleiterelement (31) vorgesehen ist.

5. Vorrichtung nach Anspruch 1 oder 3, wobei zwischen dem ersten Anschluß und dem Gate-Anschluß des zweiten Halbleiterbauelements (12) ein erstes Spannungsbegrenzungselement (32) vorgesehen ist.

6. Vorrichtung nach einem der Ansprüche 1 und 3 bis 5, wobei zwischen dem zweiten Anschluß und dem Gate-Anschluß des zweiten Halbleiterbauelements (12) ein zweites Strombegrenzungselement vorgesehen ist.

7. Vorrichtung nach einem der vorhergehenden Ansprüche, wobei
zwischen einem ersten Anschluß eines vierten Halbleiterbauelements (14) mit isoliertem Gate und dem ersten externen Anschluß (1) ein zweites Spannungshalteelement (43) vorgesehen ist,
ein Gate-Anschluß des vierten Halbleiterbauelements (14) und der externe Gate-Anschluß (3) elektrisch miteinander verbunden sind,
ein zweiter Anschluß des vierten Halbleiterbauelements (14) und der zweite externe Anschluß (2) elektrisch miteinander verbunden sind, und
eine Einrichtung vorgesehen ist, die bei Anstieg der Klemmenspannung des zweiten Spannungshalteelements (43) den Drainstrom des ersten MOSFETs (21) erhöht.

8. Vorrichtung nach einem der Ansprüche 1 und 3 bis 6, wobei das erste und das zweite Halbleiterbauelement (11, 12) MOS-Halbleiterbauelemente mit gemeinsamem Drainbereich und von diesem getrennten Hauptbereichen sind.

9. Vorrichtung nach einem der Ansprüche 2 bis 6, wobei das erste und das dritte Halbleiterbauelement (11, 13) MOS-Halbleiterbauelemente mit gemeinsamem Drainbereich und von diesem getrennten Hauptbereichen sind.

10. Vorrichtung nach einem der Ansprüche 1 und 3 bis 6, wobei das erste und das zweite Halbleiterbauelement (11, 12) IGBTs mit gemeinsamem Kollektorbereich eines ersten Leitungstyps, gemeinsamem Basisbereich eines zweiten Leitungstyps und von dem Basisbereich getrennten Hauptbereichen des ersten Leitungstyps sind.

11. Vorrichtung nach einem der Ansprüche 2 bis 6, wobei das erste und das dritte Halbleiterbauelement (11, 13) IGBTs mit gemeinsamem Kollektorbereich eines ersten Leitungstyps, gemeinsamem Basisbereich eines zweiten Leitungstyps und von dem Basisbereich getrennten Hauptbereichen des ersten Leitungstyps sind.

12. Vorrichtung nach einem der Ansprüche 1 und 3 bis 6, wobei der Hauptbereich des zweiten Halbleiterbauelements (12) und ein Halbleiterbereich des ersten Anschlusses getrennt verdrahtet sind.

13. Vorrichtung nach einem der Ansprüche 2 bis 6, wobei der Hauptbereich des dritten Halbleiterbauelements (13) und ein Halbleiterbereich des ersten Anschlusses getrennt verdrahtet sind.

14. Leistungsschaltersystem mit Strombegrenzungsfunktion zur Beaufschlagung einer Last durch Leitungs- und Unterbrechungssteuerung zwischen einem ersten und einem zweiten Anschluß mittels der Halbleitervorrichtung nach einem der vorhergehenden Ansprüche.

## Revendications

1. Dispositif à semi-conducteur à grille isolée avec un circuit de commande (91), comprenant :
un premier élément à semi-conducteur (11) à grille isolée et un circuit de commande (91) commandant ledit premier élément à semi-conducteur (11) à grille isolée sur le même boîtier (92) ;
au moins trois bornes extérieures dont une borne extérieure de grille (3), une première borne extérieure (1) et une deuxième borne extérieure (2) servant à connecter les électrodes à l'extérieur dudit boîtier (92) ;
ladite première borne extérieure (1), une première borne dudit premier élément à semi-conducteur (11) à grille isolée, une borne de terre (4) dudit circuit de commande (91), une borne de source d'un premier MOSFET (21) étant électriquement connectées ;
ladite deuxième borne extérieure (2), une deuxième borne dudit premier élément à semi-conducteur (11) à grille isolée et une deuxième borne d'un deuxième élément à semi-conducteur (12) à grille isolée du type à enrichissement étant électriquement connectées ;
ladite borne extérieure de grille (3) et une borne de grille dudit deuxième élément à semi-conducteur (12) à grille isolée du type à enrichissement étant électriquement connectées ;
un premier élément de maintien de tension (41) étant connecté entre ladite borne extérieure de grille (3) et une borne de grille (6) dudit premier élément à semi-conducteur (11) à grille isolée ;
un drain dudit premier MOSFET (21) et une première borne dudit deuxième élément à semi-conducteur (12) à grille isolée du type à enrichissement étant électriquement connectés entre ledit premier élément de maintien de tension (41) et la borne de grille dudit premier élément à semi-conducteur (11) à grille isolée ;
une borne de sortie (7) dudit circuit de commande (91) et une grille dudit premier MOSFET (21) étant électriquement connectées, grâce à quoi le courant d'alimentation pour le circuit de commande est prélevé sur le courant passant par ladite deuxième borne extérieure.

2. Dispositif à semi-conducteur à grille isolée avec un circuit de commande (91), comprenant :
un premier élément à semi-conducteur (11) à grille isolée et un circuit de commande (91) commandant ledit premier élément à semi-conducteur (11) à grille isolée sur le même boîtier (92) ;
au moins trois bornes extérieures dont une borne extérieure de grille (3), une première borne extérieure (1) et une deuxième borne extérieure (2) servant à connecter les électrodes à l'extérieur dudit boîtier (92) ;
ladite première borne extérieure (1), une première borne dudit premier élément à semi-conducteur (11) à grille isolée, une borne de terre (4) dudit circuit de commande (91) et une borne de source d'un premier MOSFET (21) étant électriquement connectées ;
ladite deuxième borne extérieure (2), une deuxième borne dudit premier élément à semi-conducteur (11) à grille isolée et une deuxième borne d'un troisième élément à semi-conducteur (13) à grille isolée du type à enrichissement étant électriquement connectées ;
ladite borne extérieure de grille (3) et une borne de grille dudit troisième élément à semi-conducteur (13) à grille isolée du type à enrichissement étant électriquement connectées ;
un premier élément de maintien de tension (41) étant connecté entre ladite borne extérieure de grille (3) et une borne de grille (6) dudit premier élément à semi-conducteur (11) à grille isolée ;
un drain dudit premier MOSFET (21) étant électriquement connecté entre ledit premier élément de maintien de tension (41) et la borne de grille dudit premier élément à semi-conducteur (11) à grille isolée ;
une borne de sortie (7) dudit circuit de commande (91) et une grille dudit premier MOSFET (21) étant électriquement connectées ; et
une première borne dudit troisième élément à semi-conducteur (13) à grille isolée du type à enrichissement et une borne (5) de source d'alimentation électrique dudit circuit de commande (91) étant électriquement connectées.

3. Dispositif selon la revendication 1, comprenant en outre un troisième élément à semi-conducteur (13) à grille isolée du type à enrichissement ayant une première borne connectée à une borne (5) de source d'alimentation électrique dudit circuit de commande (91), une deuxième borne connectée à ladite deuxième borne extérieure (2) et une borne de grille connectée à ladite borne extérieure de grille (3).

4. Dispositif selon la revendication 1 ou 3, dans lequel un élément conduisant unidirectionnellement le courant est disposé entre la première borne dudit deuxième élément à semi-conducteur (12) à grille isolée du type à enrichissement et la borne de grille dudit premier élément à semi-conducteur (11) à grille isolée.

5. Dispositif selon la revendication 1 ou 3, dans lequel un premier élément limiteur de tension (32) est disposé entre la première borne et la borne de grille dudit deuxième élément à semi-conducteur (12) à grille isolée du type à enrichissement.

6. Dispositif selon l'une quelconque des revendications 1 et 3 à 5, dans lequel un deuxième élément limiteur d'intensité est disposé entre la deuxième borne et la borne de grille dudit deuxième élément à semi-conducteur (12) à grille isolée du type à enrichissement.

7. Dispositif selon l'une quelconque des revendications précédentes, dans lequel
un deuxième élément de maintien de tension (43) est disposé entre une première borne d'un quatrième élément à semi-conducteur (14) à grille isolée et la première borne extérieure (1) ;
une borne de grille dudit quatrième élément à semi-conducteur (14) à grille isolée et ladite borne extérieure de grille (3) sont électriquement connectées ;
une deuxième borne dudit quatrième élément à semi-conducteur (14) à grille isolée et ladite deuxième borne extérieure (2) sont électriquement connectées ; et
un moyen pour accroître l'intensité d'un courant de drain dudit premier MOSFET (21), lorsqu'une tension de borne dudit deuxième élément de maintien de tension (43) augmente, est présent.

8. Dispositif selon l'une quelconque des revendications 1 et 3 à 6, dans lequel lesdits premier et deuxième éléments à semi-conducteur (11, 12) à grille isolée sont des éléments à semi-conducteur du type MOS ayant une région de drain commune et ayant des régions de corps séparées par ladite région de drain.

9. Dispositif selon l'une quelconque des revendications 2 à 6, dans lequel lesdits premier et troisième éléments à semi-conducteur (11, 13) à grille isolée sont des éléments à semi-conducteur du type MOS ayant une région de drain commune et ayant des régions de corps séparées par ladite région de drain.

10. Dispositif selon l'une quelconque des revendications 1 et 3 à 6, dans lequel lesdits premier et second éléments à semi-conducteur (11, 12) à grille isolée sont des transistors bipolaires à grille isolée ayant une région de collecteur d'un premier type de conductivité, une région de base commune d'un deuxième type de conductivité et des régions de corps d'un premier type de conductivité, séparées par une région de base d'un deuxième type de conductivité.

11. Dispositif selon l'une quelconque des revendications 2 à 6, dans lequel lesdits premier et troisième éléments à semi-conducteur (11, 13) à grille isolée sont des transistors bipolaires à grille isolée ayant une région de collecteur commune d'un premier type de conductivité, une région de base commune d'un deuxième type de conductivité et des régions de corps d'un premier type de conductivité, séparées par une région de base d'un deuxième type de conductivité.

12. Dispositif selon l'une quelconque des revendications 1 et 3 à 6, dans lequel la région de corps dudit deuxième élément à semi-conducteur (12) à grille isolée et une région à semi-conducteur de la première borne sont câblées séparément.

13. Dispositif selon l'une quelconque des revendications 2 à 6, dans lequel la région de corps dudit troisième élément à semi-conducteur (13) à grille isolée et une région à semi-conducteur de la première borne sont câblées séparément.

14. Système de commutateur de puissance à fonction de limitation de courant pour entraîner une charge par commande de conduction et de blocage entre une première et une deuxième bornes par le dispositif à semi-conducteur à grille isolée selon l'une quelconque des revendications précédentes.
